# EUROPEAN PATENT APPLICATION

(11) **EP 2 549 652 A2**
(43) Date of publication of application: **23.01.2013**
(21) Application number: 12176787.5
(22) Date of filing: 17.07.2012
(51) Int. Cl.: H03K 17/96

(54) **Motion sensing switch**

(30) Priority: 18.07.2011 KR 20110070964
(71) Applicant: Hysonic. Co., Ltd., Gyeonggi-Provine 426-901 (KR)
(72) Inventor: Jung, He Won, 426-901 Ansan-city, Gyeonggi-Province (KR); Choi, Jun Sam, 426-901 Ansan-city, Gyeonggi-Province (KR)
(74) Representative: Negrini, Elena

(57) **Abstract**

The present invention relates to a motion sensing switch, and more particularly to a motion sensing switch which can sense external motions without any touching operation. The motion sensing switch of the present invention includes a base (100); a light receiving device (200) which is disposed at the base; a plurality of light emitting devices (300) which are disposed at the base so as to be symmetric with respect to the light receiving device; a control part which operates the light emitting devices (300), wherein the light emitting devices are disposed to be inclined (120) in an opposite direction to the light receiving device, and the light receiving device senses light emitted from the light emitting devices and reflected by a reflection body (F) and then transfers an operation signal to the control part (mounted on 500), and the control part receives the operation signal and recognizes motion of the reflection body.

## Description

### FIELD OF THE INVENTION

The present invention relates to a motion sensing switch, and more particularly, to a motion sensing switch which can sense external motion without any touching.

### BACKGROUND OF THE INVENTION

As an electronic communication technology is developed, a portable terminal such as a mobile phone and a PDA becomes one of the necessities in modem society. The portable terminal has been improved to have a new special function and to be easily operated, thereby attracting consumer's eyes.

Recently, the portable terminal provides various additional functions such as an Internet accessing function, a game function as well as a communication function and also has a plurality of key buttons which can select and control the various functions.

Since the portable terminal has a small size in order to provide mobility and portability, the number of key buttons is limited.

Therefore, it is difficult to exactly select the key buttons arranged in a narrow space, and particularly when a user is under behavioral restrictions, for example, when the user is moving or driving, it is very difficult to perform an input motion using the key buttons.

Further, due to simple input patterns which press the key buttons, the many number of key button input operations is needed to continuously perform a scroll function, a zoom-in/out function or the like, and also since characteristics of the functions which are performed are not reflected on the input operations, it is difficult for the user to remember operational functions.

To solve the problems, there has been proposed a technology having a control function operated by sensing motion of a user, which can control functions of a portable terminal through a non-contact type operation without directly contacting with an input unit such as a key pad.

The control function can be also applied to various fields such as an interface device, a motion recognition game, a vehicle panel and a kitchen appliance.

In order to improve a recognition rate and responsibility the motion in the non-contact type control function, the device thereof has to have a large size.

If the non-contact type device has a large size, a distance between sensors for sensing the motion is far apart from each other, and thus it is facile to sense the motion from a long distance away.

However, since the non-contact type device needs to have a small size in order to apply the non-contact type function to a small-sized apparatus, the distance between the sensors becomes short, and thus the motions are not sensed from a long distance away or it is not possible to sensitively respond to a control operation, thereby being inconvenient in controlling the various small-sized apparatuses.

### SUMMARY OF THE INVENTION

An embodiment of the present invention is directed to providing a motion sensing switch which has a high recognition rate with respect to external motion from a long distance away and also sensitively responds to the external motion, thereby being convenient in controlling various apparatuses.

To achieve the object of the present invention, the present invention provides a motion sensing switch including a base; a light receiving device which is disposed at the base; a plurality of light emitting devices which are disposed at the base so as to be symmetric with respect to the light receiving device; a control part which operates the light emitting devices, wherein the light emitting devices are disposed to be inclined in an opposite direction to the light receiving device, and the light receiving device senses light emitted from the light emitting devices and reflected by a reflection body and then transfers an operation signal to the control part, and the control part receives the operation signal and recognizes motion of the reflection body.

Preferably, the base comprises a plane portion on which the light receiving device is mounted; and an inclined portion which is formed to be inclined downward toward an external side of the plane portion so that the light emitting device is disposed to be inclined.

Preferably, a partition wall is formed to be protruded between the plane portion and the inclined portion.

Preferably, fourth inclined portions are disposed around the plane portion 110 to be spaced apart from each other at an angular interval of 90°, and the partition wall is disposed to enclose the light receiving device so that each surface of the partition wall is corresponding to the inclined portion, and a light transmittance cover which is covered on the light receiving device so as to transmit the light reflected from the reflection body is disposed on the partition wall, and the inclined portion is formed to be inclined at the same angle so that each light emitting device is disposed on the inclined portion to be inclined at the same angle.

### BRIEF DESCRIPTION OF THE DRAWINGS

These and other characteristics of the invention will be clear from the following description of a preferential form of embodiment, given as a non-restrictive example, with reference to the attached drawings, in which:
- Fig. 1 shows a perspective view of a motion sensing switch according to an embodiment of the present invention;
- Fig. 2 shows an exploded perspective view of the motion sensing switch according to the embodiment of the present invention;
- Fig. 3 shows a cross-sectional view taken along a line A-A of Fig. 1;
- Fig. 4 shows a cross-sectional view taken along a line B-B of Fig. 1;
- Fig. 5a shows a view showing an emission angle of light emitted from a light emitting device according to an embodiment of the present invention;
- Fig. 5b shows a view showing an emission angle of light emitted from a light emitting device which is disposed at an inclined portion formed to be parallel with a plane portion;
- Fig. 6a shows a view showing distribution cross-sections of light when seeing from a height D1 of Fig. 5a;
- Fig. 6b shows a view showing distribution cross-sections of light when seeing from the height D1 of Fig. 5b;
- Fig. 7a shows a view showing distribution cross-sections of light when seeing from a height D2 of Fig. 5a; and
- Fig. 7b shows a view showing distribution cross-sections of light when seeing from the height D2 of Fig. 5b.

### DETAILED DESCRIPTION OF A PREFERED EMBODIMENT

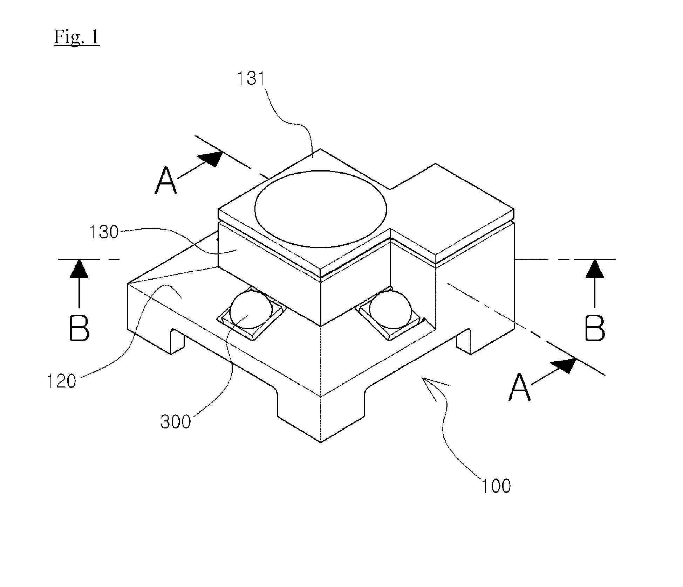

As shown in Figs. 1 to 4, the motion sensing switch according to the embodiment of the present invention includes a base 100, a light receiving device 200, a light emitting device 300, a compensation device 400, a circuit board 500 and a control device (not shown).

The advantages, features and aspects of the invention will become apparent from the following description of the embodiments with reference to the accompanying drawings, which is set forth hereinafter.

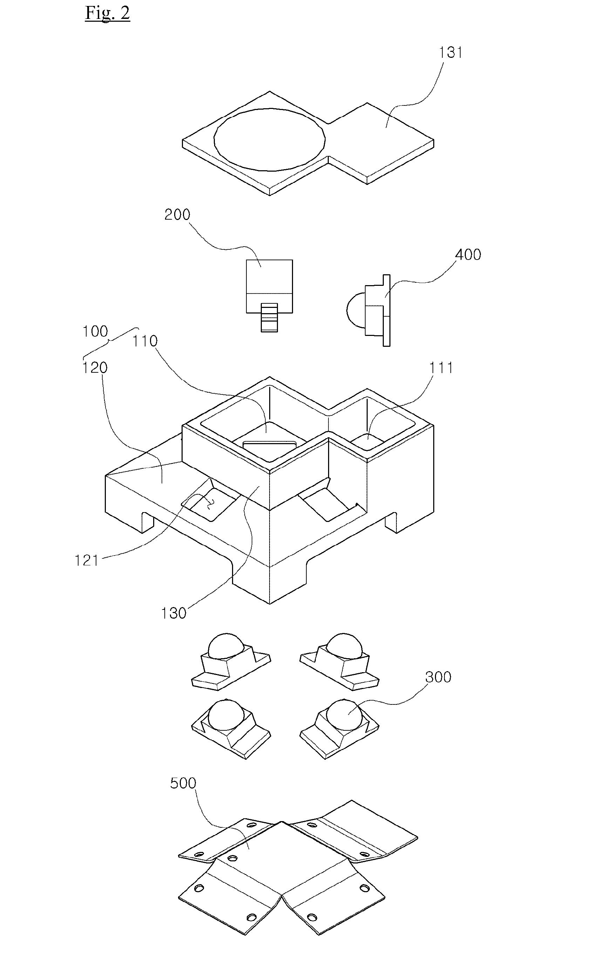

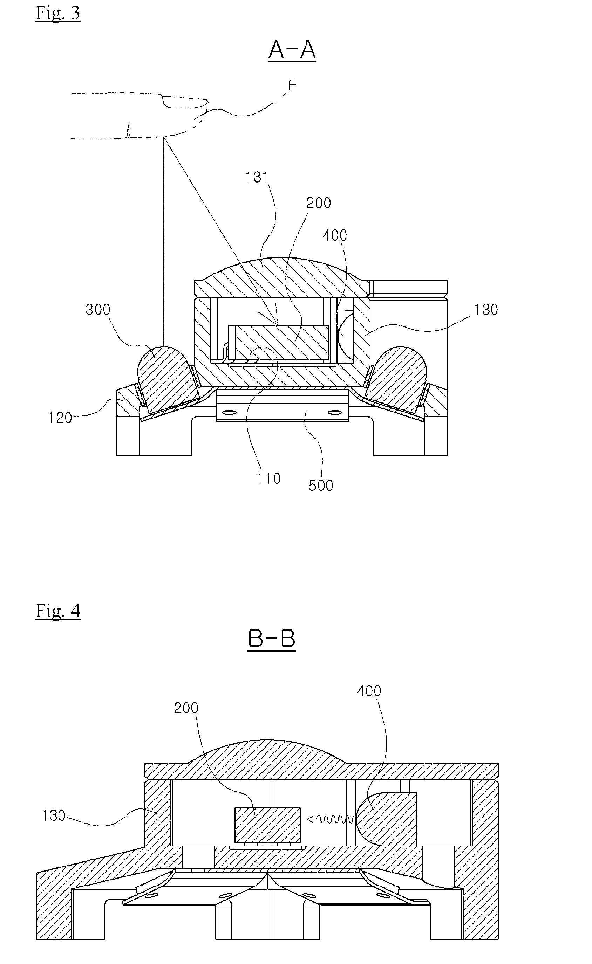

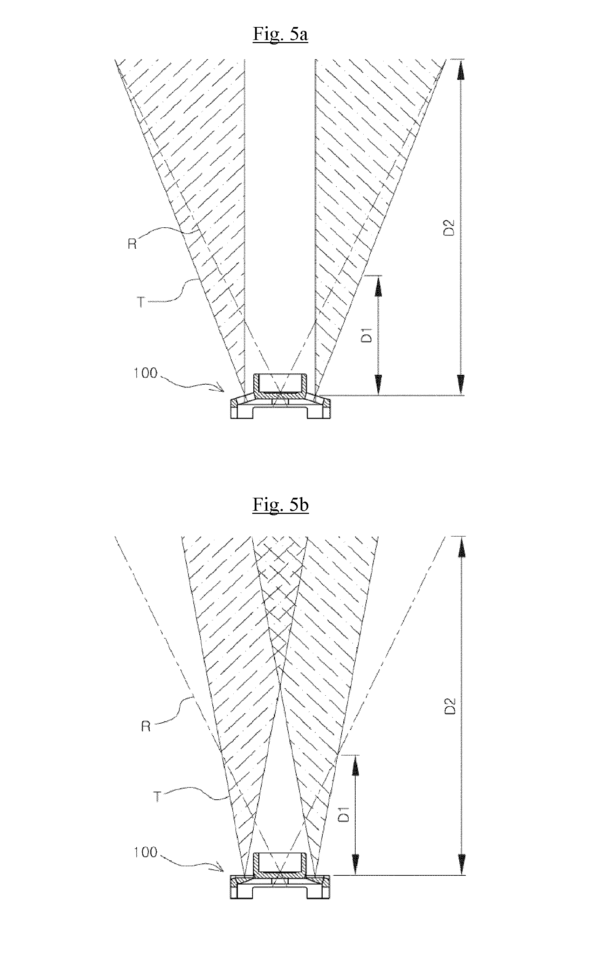

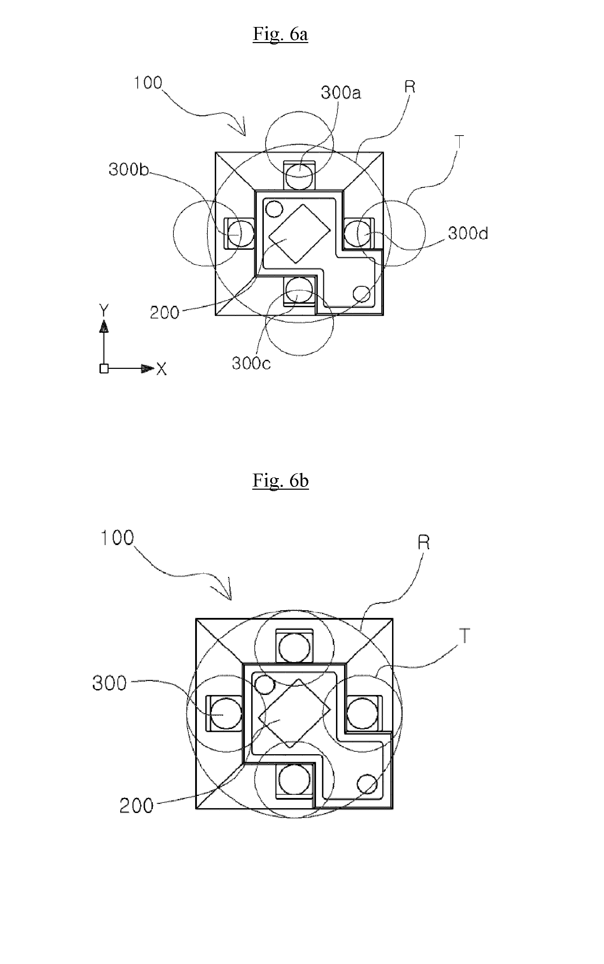

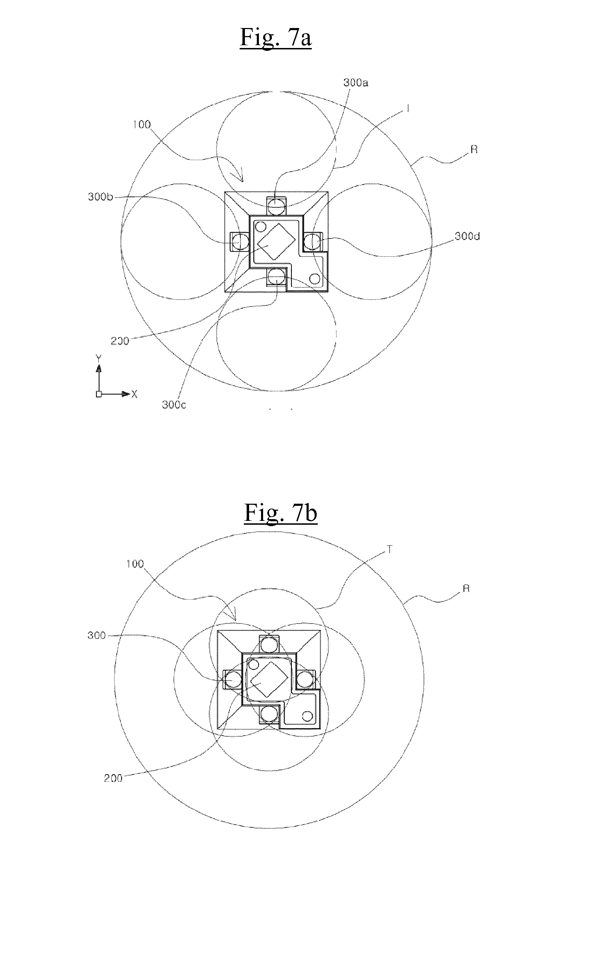

Fig. 1 is a perspective view of a motion sensing switch according to an embodiment of the present invention, Fig. 2 is an exploded perspective view of the motion sensing switch according to the embodiment of the present invention, Fig. 3 is a cross-sectional view taken along a line A-A of Fig. 1, Fig. 4 is a cross-sectional view taken along a line B-B of Fig. 1, Fig. 5a is a view showing an emission angle of light emitted from a light emitting device according to an embodiment of the present invention, Fig. 5b is a view showing an emission angle of light emitted from a light emitting device which is disposed at an inclined portion formed to be parallel with a plane portion, Fig. 6a is a view showing distribution cross-sections of light when seeing from a height D1 of Fig. 5a, Fig. 6b is a view showing distribution cross-sections of light when seeing from the height D1 of Fig. 5b, Fig. 7a is a view showing distribution cross-sections of light when seeing from a height D2 of Fig. 5a, and Fig. 7b is a view showing distribution cross-sections of light when seeing from the height D2 of Fig. 5b.

As shown in Figs. 1 to 4, the motion sensing switch according to the embodiment of the present invention includes a base 100, a light receiving device 200, a light emitting device 300, a compensation device 400, a circuit board 500 and a control device (not shown).

The base 100 is installed at various apparatuses which are operated by sensing motion of a portable terminal or other external object.

Particularly, the motion sensing switch according to the embodiment is to miniaturize a whole size of an apparatus and also to more sensitively sense the motion of the external object. It is more effective that the motion sensing switch is installed at a small and slim apparatus.

Further, the motion sensing switch can be applied to various convenient apparatuses or safety apparatuses.

The base 100 consists of a plane portion 110 and an inclined portion 120.

As shown in Figs. 2 and 3, the light receiving device 200 is mounted on the plane portion 110. [0030] And as shown in Figs. 2 and 3, a mounting portion 111 on which the compensation device 400 is mounted is formed from a side surface of the plane surface 110.

As shown in Figs. 1 to 3, the inclined portion 120 is formed to be inclined downward toward an external side of the plane portion 110.

More detailedly, the four inclined portions 120 are disposed around the plane portion 110 to be spaced apart from each other at an angular interval of 90°.

The inclined portions 120 are formed to be inclined downward at the same angle and also to be directed to the external side of the plane portion 110.

The inclined portions 120 are respectively formed with a coupling hole 121 which is passed through.

The light emitting device 300 is inserted into the coupling hole 121 so as to be inclinedly disposed on the inclined portion 120.

In Fig. 5, only the base 100 is shown in order to check an angle of light emitted from the light emitting device 300.

Fig. 5a shows a light emitting and receiving angle in the motion sensing switch according to the embodiment of the present invention, and Fig. 5b shows a light emitting and receiving angle in the motion sensing switch in which the inclined portion 120 is formed to be parallel with the plane portion 110.

The light emitted from the light emitting device 300 is not emitted straightly but emitted in a streamline shape. However, for convenience of explanation, it is shown in a straight line, as shown in Fig. 5.

When comparing Figs. 5a and 5b, the inclined portion 120 is disposed to be inclined downward and also to be directed toward the external side of the plane portion 110, and thus the light emitted from the light emitting device 300 mounted on the inclined portion 120 is directed inclinedly in an opposite direction to the light receiving device 200 mounted on the plane portion 110.

As shown in Fig. 6, the light emitted from each light emitting device 300 is not overlapped with each other within a distance D1, and thus it is facile that the control device (not shown) distinguishes the light which is emitted from the light emitting device 300 and then reflected by a reflection body F.

However, in case of the reflection body F which is moved over the distance D 1 from the motion sensing switch in which the inclined portion 120 is parallel with the plane portion 110, as shown in Fig. 7b, an emission range T of the light emitted from each light emitting device 300 is overlapped within a range that the light receiving device 200 is receives the light.

If the reflection body F is moved at the overlapped portion of the emission range T, it is difficult for the control device to distinguish from which light emitting device the light reflected from the reflection body F and sensed by the light receiving device 200 is emitted, and thus it is also difficult to ascertain a position and movement of the reflection body F.

However, in the embodiment, the inclined portion 120 is formed to be inclined with respect to the plane portion 110, and the light emitting device 300 is mounted on the inclined portion 120 so as to emit the light. Therefore, as shown in Fig. 7a, the emission range T of the light emitted from the light emitting device 300 is not overlapped within the distance between D1 and D2 from the motion sensing switch, and thus it is facile to distinguish from which light emitting device 300 the light sensed by the light receiving device 200, thereby sensitively sensing the position and movement of the reflection body F.

As described above, since the inclined portion 120 is formed to be inclined with respect to the plane portion 110 and the light is emitted from the light emitting device 300 mounted on the inclined portion 120, it is possible to miniaturize the motion sensing switch and also to sensitively sense the position and movement of the reflection body F from a long distance away.

The distance D1, D2 between the motion sensing switch and the reflection body F is changed according to an inclined angle of the inclined portion 120 and an emission angle of the light emitted from the light emitting device 300.

A partition wall 130 is formed between the plane portion 110 and the inclined 120.

As shown in Figs. 2 to 4, the partition wall 130 is formed to enclose the light receiving device 200, such that each surface of the partition wall 130 is corresponding to each inclined portion 120.

Further, the partition wall 130 is disposed to enclose the compensation device 400.

Therefore, the light receiving device 200 and the compensation device 400 are disposed in the partition wall 130.

A light transmittance cover 131 which is covered on the light receiving device 200 so as to transmit the light reflected from the reflection body F is disposed on the partition wall 130.

The light receiving device 200 is mounted on the base 100.

In other words, the light receiving device 200 is disposed on the plane portion 110 and enclosed by the partition wall 130, as described above.

The light receiving device 200 cannot directly receive the light which is emitted from the light emitting device 300 but not reflected by the reflection body F. The light receiving device 200 functions to sense the light emitted from the light emitting device 300 and reflected by the reflection body F and then transfer an operation signal to the control device.

Therefore, confusion in the sensing of the motion of the reflection body F, which is occurred by sensing the light emitted from the light emitting device 300 but not reflected by the reflection body F, is prevented.

More detailedly, the light receiving device 200 is a photodiode for generating current when sensing light.

The current generated in the light receiving device 200 is used as the operation signal, and the operation signal is transferred to the control device.

The four light emitting devices 300 are respectively inserted into the coupling hole 121 formed in each inclined portion 120 so as to be inclined in the opposite direction to the light receiving device 200.

And each light emitting device 300 is disposed to be inclined at the same angle.

If necessary, the inclined portion 120 may be formed to be parallel with the plane portion 110 and the light emitting device 300 may be disposed to be inclined with respect to the inclined portion 120.

The light emitting device 300 is an IR(Infrared Rays) LED which emits infrared light.

The infrared light emitted upward from the light emitting device 300 is reflected to the light receiving device 200 by the reflection body F which is moved on the motion sensing switch.

The reflection body F may be a part of a user's body or various tools moved by the user, which functions to operate an apparatus in which the motion sensing switch is installed.

The compensation device 400 is mounted on the mounting portion 111 so as to emit infrared light to the light receiving device 200.

As shown in Fig. 4, the compensation device 400 is disposed in the light receiving device 200 together with the partition wall 130 and also disposed toward the light receiving device 200, such that the light receiving device 200 can directly sense the light emitted from the compensation device 400.

As described above, the compensation device 400 emits the light to the light receiving device 200 and compensates the operation signal generated from the light receiving device 200 by the light emitted from the light emitting device 300 and reflected from the reflection body F.

The detailed method thereof will be described later.

The circuit board 500 is disposed at a lower side of the base 100 so as to be electrically connected with the light receiving device 200, the light emitting device 300 and the compensation device 400, and the control device is mounted on the circuit board 500.

The control device operates the light emitting device 300.

As described above, the control device is mounted on the circuit board 500 and operates the light emitting device 300 to emit the light.

The control device operates each of the four light emitting devices 300 so that the four light emitting devices 300 are repeatedly operated in turn.

Further, the control device receives the operation signal generated from the light receiving device 200 and operates the compensation device 400 in response to the operation signal, and the motion of the reflection body F can be recognized with the operation signal compensated by the compensation device 400.

Hereinafter, a method of operating the motion sensing switch according to the present invention, as described above, will be described.

The control part operates repeatedly the light emitting devices 300 in turn so as to emit the light to the upper side of the motion sensing switch.

By operating the light emitting devices 300 in turn, it is facile to distinguish the light emitted from the four light emitting devices 300.

The light emitted from one of the light emitting devices 300 is reflected by the reflection body F and then sensed by the light receiving device 200. The intensity of the light reflected by the reflection body F is changed according to the movement of the reflection body F.

As described above, while the intensity of the light emitted from one of the light emitting devices 300 and reflected by the reflection body F is changed, the light emitted from the rest light emitting devices 300 is not reflected by the reflection body F and thus cannot be sensed by the light receiving device 200, or even though the light emitted from the rest light emitting devices 300 is reflected by the reflection body F and then sensed by the light receiving device 200, the change in the intensity thereof is small, and thus the control device can distinguish and ascertain the light emitting device 100, which emits the light reflected by the reflection body F and sensed by the light receiving device 200, on the basis of the change in the current generated by the light sensed by the light receiving device 200, i.e. the intensity of the operation signal. Therefore, the control part can ascertain the position and movement of the reflection body F.

Detailedly, since the light emitted from the light emitting device 300 and reflected by the reflection body F has a certain wavelength, the light receiving device 200 that senses the light generates an alternating current and then transfers the AC type operation signal to the control device.

However, since it is difficult for the control device to measure the intensity of an AC type operation signal, the compensation device 400 emits the light according to the intensity and type of the light sensed by the light receiving device 200 and thus compensates the light to be sensed by the light receiving device 200.

Therefore, the light receiving device 200 generates a direct current based on the compensated light and transfers a DC type operation signal to the control device.

Thus, the control device analyzes the intensity and characteristic of the signal on the basis of the operation signal and checks the position and movement of the reflection body F, thereby operating the apparatus with the motion sensing switch according to the motion of the reflection body F.

More detailedly, as shown in Figs. 6 and 7, the light emitting device 300 includes a first light emitting device 300a, a second light emitting device 300b, a third light emitting device 300c and a fourth light emitting device 300d. If the reflection body F is moved from the first light emitting device 300a to the third light emitting device 300c, the intensity of the light emitted from the first light emitting device 300a and sensed by the light receiving device 200 is increased and then reduced, and the intensity of the light emitted from the third light emitting device 300c and sensed by the light receiving device 200 is increased and then reduced.

As described above, the light receiving device 200 generates the operation signal according to the change in the intensity of the light emitted from the first and second light emitting devices 300a and 300c. The control device receives the operation signal and recognizes that the reflection is moved in a y axial direction, i.e., from the first light emitting device 300a to the third light emitting device 300c.

Meanwhile, when the reflection body is moved from the third light emitting device 300c to the first light emitting device 300a, the intensity of the light emitted from the third light emitting device 300c is firstly changed and the intensity of the light emitted from the first light emitting device 300a is then changed.

Further, if the reflection body F is moved from the second light emitting device 300b to the fourth light emitting device 300d, the intensity of the light emitted from the second light emitting device 300b and sensed by the light receiving device 200 is increased and then reduced, and the intensity of the light emitted from the fourth light emitting device 300d and sensed by the light receiving device 200 is increased and then reduced.

Thus, the control device recognizes that the reflection is moved in an x axial direction.

And a z axial movement, i.e., an up/down movement of the reflection body F can be recognized by time necessary for the light receiving device 200 to sense the light emitted from the light emitting device 300 and reflected by the reflection body F.

In other words, as a distance between the reflection body F and the light receiving device 200 becomes long, the time necessary for the light receiving device 200 to sense the light is increased. And as the distance between the reflection body F and the light receiving device 200 becomes short, the time necessary for the light receiving device 200 to sense the light is decreased.

As described above, the control device can recognize the three-dimensional motion of the reflection F and thus can operate the apparatus with the motion sensing switch according to the movement of the reflection body F.

Since the motion sensing device includes the inclined portion 120 and the plane portion 110, and the light emitting device 300 is on the inclined portion 120 so that the light emitted from the light emitting device 300 is emitted inclinedly in the opposite direction to the light receiving device 200, even when the reflection body F is spaced apart from the motion sensing switch, it is minimized that the emission range T of the light emitted from each light emitting device 300 is overlapped, and thus it is possible to miniaturize the motion sensing switch and also to sensitively sense the motion of the reflection body F from a long distance away.

Thus, the motion sensing switch can be applied to various small apparatuses so as to conveniently control them without any touching of them.

According to the motion sensing switch of the present invention, since the light emitted from the light emitting device is emitted inclinedly in the opposite direction to the light receiving device so as to minimize the interference range of the light to be emitted from each light emitting device, it is possible to miniaturize the motion sensing switch and to sensitively sense the motion of the reflection body F from a long distance away, and it is also possible to facilely control the small apparatuses without any touching of them.

Further, since the partition wall is disposed to be protruded between the plane portion and the inclined portion, it is prevented that the light emitted from the light emitting device is not reflected by the reflection body but is directly sensed by the light receiving device, thereby preventing the confusion in the sensing of the motion of the reflection body F.

Further, since the inclined portions are formed to be inclined at the same angle and each light emitting device is disposed to be inclined at the same angle, the distance in which the light emitted from each light emitting device is not overlapped is increased, and thus the range which can sensitively sense the motion of the reflection body is increased.

While the present invention has been described with respect to the specific embodiments, it will be apparent to those skilled in the art that various changes and modifications may be made without departing from the spirit and scope of the invention as defined in the following claims.

## Claims

1. A motion sensing switch, comprising:
- a base;
- a light receiving device which is disposed at the base;
- a plurality of light emitting devices which are disposed at the base so as to be symmetric with respect to the light receiving device;
- a control part which operates the light emitting devices,
wherein the light emitting devices are disposed to be inclined in an opposite direction to the light receiving device, and the light receiving device senses light emitted from the light emitting devices and reflected by a reflection body and then transfers an operation signal to the control part, and the control part receives the operation signal and recognizes motion of the reflection body.

2. The motion sensing switch as in claim 1, wherein the base comprises a plane portion on which the light receiving device is mounted; and an inclined portion which is formed to be inclined downward toward an external side of the plane portion so that the light emitting device is disposed to be inclined.

3. The motion sensing switch as in claim 2, wherein a partition wall is formed to be protruded between the plane portion and the inclined portion.

4. The motion sensing switch as in claim 3, wherein fourth inclined portions are disposed around the plane portion 110 to be spaced apart from each other at an angular interval of 90°, and the partition wall is disposed to enclose the light receiving device so that each surface of the partition wall is corresponding to the inclined portion, and a light transmittance cover which is covered on the light receiving device so as to transmit the light reflected from the reflection body is disposed on the partition wall, and the inclined portion is formed to be inclined at the same angle so that each light emitting device is disposed on the inclined portion to be inclined at the same angle.
